# EUROPEAN PATENT SPECIFICATION

(11) **EP 2 516 691 B1**
(45) Date of publication and mention of the grant of the patent: **24.10.2018**
(21) Application number: 10805278.8
(22) Date of filing: 22.12.2010
(51) Int. Cl.: B81C 1/00, B32B 43/00, B01J 37/02, B01J 21/18, C23C 14/00, B01J 23/28, B01J 23/38, B01J 23/44, B01J 23/74, B01J 35/00, B32B 33/00, B01J 37/34, B82Y 30/00, B82Y 40/00, B32B 37/24

(54) **PRODUCTION OF FUNCTIONALISED SUBSTRATE**
HERSTELLUNG EINES FUNKTIONALISIERTEN SUBSTRATS
PRODUCTION D'UN SUBSTRAT FONCTIONNALISÉ

(30) Priority: 23.12.2009 GB 0922581
(43) Date of publication of application: 31.10.2012
(73) Proprietor: The University of Birmingham, Edgbaston, Birmingham B15 2TT (GB)
(72) Inventor: PALMER, Richard, Stourbridge West Midlands DY8 2XW (GB); SONG, Mi Yeon, Seoul 130-860 (KR)
(74) Representative: Bailey, Jennifer Ann
(86) International application number: PCT/GB2010/002316
(87) International publication number: WO 2011/077089

(56) References cited:
- EP-A1- 1 930 270
- US-A- 3 949 139
- US-A1- 2007 020 445
- VEITH ET AL: "Magnetron sputtering of gold nanoparticles onto WO3 and activated carbon", CATALYSIS TODAY, ELSEVIER, NL, vol. 122, no. 3-4, 10 May 2007 (2007-05-10), pages 248-253, XP022068739, ISSN: 0920-5861, DOI: DOI:10.1016/J.CATTOD.2007.01.010

## Description

The present invention relates to a method of producing a functionalised substrate. Such substrates may find application in catalysis, optics, bioscience and surface science.

The immobilisation of metal clusters on a substrate is well known in the art. Such immobilised clusters are typically formed by placing the substrate (typically of the order of 0.5 x 1.0 cm) in a vacuum chamber, and directing clusters towards the substrate by use of electromagnetic fields. The clusters themselves may be produced from a bulk source by sputtering, evaporation, electrospray, laser ablation, or other similar techniques. The size of cluster deposited can be selected through mass or energy filtration, such as for example 'time of flight' (TOF). Where appropriate, such as when the functionalised substrate is to be used in subsequent chemical reactions (for example where it has catalytic properties), it is typically ground into a powder before use, such as for example in a pestle and mortar.

However, existing processes are not well suited to commercial production. In order to create the functionalised substrate, the substrate requires a certain level of structural integrity. This is usually achieved by providing a substrate having a sufficient thickness. However, an increased thickness of substrate limits the ratio of functionalised surface to volume, and hence limits the commercial value of the functionalised substrate.

US3949139 describes a process of producing laminar reflective platelets comprising coating a carrier web with a release layer, a synthetic resin layer and then a metallic layer, and exposing the coated web to a solvent for the release layer, thereby separating platelets from the carrier web.

There is therefore a desire for a method of producing a functionalised substrate in which the efficiency of the process, and the commercial value of the product, can be maximised. The present invention has been conceived with these desires and needs in mind.

According to a first aspect of the invention, there is provided a method of producing a substrate functionalised with metallic clusters, comprising providing a laminar substrate, depositing metallic clusters on a surface of the substrate to thereby create a functionalised surface layer, and separating one or more layers of the substrate including the functionalised surface layer from one or more remaining layers of the substrate, wherein separating one or more layers of substrate comprises making a series of cuts across the layers to be separated, and thereby causing the layers to delaminate from the laminar substrate.

The methods described herein enable convenient commercial production of functionalised substrate. The separation of one or more layers including the functionalised surface layer from one or more remaining layers of the substrate reduces the thickness of substrate on which the metal clusters are deposited. This increases the relative proportion of the functionalised substrate formed by the functionalised surface layer (and hence reduces the proportion formed by unfunctionalised sub-surface layers). At the same time, the presence of the additional (i.e. 'remaining') layers before and during the metallic cluster deposition process provides structural strength to the substrate.

The substrate may be in the form of a tape, sheet, disc or any other suitable form.

It will be understood that the substrate must have a laminar structure to allow separation of the layers. The layers of the substrate may be substantially identical, or the substrate may be a composite structure comprising different layers. In the latter case, the layers may be differentiated by chemical or physical characteristics, or a combination of the two. For example, the layers may have the same chemical composition with a different crystal structure, or with the same crystal structure in a different orientation, or the layers may have entirely different chemical compositions.

In general, the choice of substrate material (at least in relation to the surface layer) will be familiar to the skilled reader according to the purpose for which the functionalised substrate is intended. Typically, at least the surface layer of the substrate will be inert to the chemicals to which the functionalised substrate is to be exposed (for example, if the functionalised substrate has catalytic properties, the chemicals that will be present in the reaction mixture to be catalysed). It may also be advantageous for the substrate material to be non-toxic to human or other life. In many cases, the substrate will have a flat (or substantially flat) surface (at the atomic level) to allow metallic clusters to be deposited as required. Suitable substrate materials may, in certain applications, include those selected from metals, metal oxides (e.g. SnO, MgO, TiO₂), transition metal chalcogenides, silicon, and graphite. In particular, examples of laminar materials suitable for forming a laminar substrate include graphite and MoS₂.

In some embodiments, the laminar substrate is in the form of a tape. The use of a tape as the substrate for metallic cluster deposition permits large quantities of functionalised substrate to be produced, since the tape can be passed continually in front of the deposition source until the required degree of deposition has taken place and the entire length of the tape has been functionalised. Provided that the tape has a suitable level of flexibility, it can be stored as spools within the apparatus, and simply unwound from a source spool and wound on to a target spool as required. In this way, it is possible to functionalise long lengths of substrate without requiring a corresponding increase in the size of the apparatus (e.g. vacuum chamber).

In some embodiments, the substrate may have a composite structure comprising at least a base layer, a surface layer, and a sacrificial layer positioned between the base layer and surface layer, and depositing metallic clusters on a surface of the substrate comprises depositing metallic clusters on the surface layer. It will be understood that the sacrificial layer and surface layer will generally be different in composition; the base layer may be of similar composition to either the sacrificial layer or surface layer, or all three layers may be of different composition.

The composition of the sacrificial layer should be such that the surface layer may easily be separated from the base layer. For example, the sacrificial layer may have a lower (compared to the surface layer or the base layer) degree of resistance to degradation (such as chemical degradation or degradation caused by actinic radiation, such as for example electromagnetic radiation). Alternatively or additionally, the sacrificial layer may have a significantly greater solubility in certain solvents, or may be convertible (such as by exposure to actinic radiation) to a composition having greater solubility. Thus, in some further embodiments, separating one or more layers of the substrate including the functionalised surface layer from one or more remaining layers of the substrate comprises selectively removing the sacrificial layer. Alternatively or additionally, the sacrificial layer may have a relatively low degree of adhesion to the surface layer.

Such a substrate construction facilitates the production of functionalised substrate, since it allows the easy removal of the functionalised surface layer in a reproducible manner. In particular, it may allow the surface layer to be of very low thickness, such as of a similar thickness to the deposited layer of metallic clusters. The separation of such thin layers in the absence of a sacrificial layer (such as through purely mechanical means) would be difficult, and would risk disturbance of the deposited layer of metallic clusters.

In some embodiments, the method further comprises the preparation of the laminar substrate. The layers may be built up by any conventional method for depositing thin layers, such as for example by sputtering.

The metallic clusters may be deposited on the substrate by any suitable method. For example, the metallic clusters may be deposited onto the substrate from a solution (e.g. as micelles). Alternatively, the metallic clusters may be deposited by placing the substrate in a vacuum chamber, and directing clusters towards the substrate by use of electromagnetic fields. The clusters themselves may be produced from a bulk source by sputtering, evaporation, electrospray, laser ablation, or other similar techniques. The size of cluster deposited can be selected through mass or energy filtration, such as for example 'time of flight' (TOF).

It will be understood that separation of one or more layers of the substrate including the functionalised surface layer from one or more remaining layers of the substrate may comprise separation of one or more intact layers including the functionalised surface layer from one or more intact remaining layers. Alternatively, one or both of the one or more layers including the functionalised surface layer and the one or more remaining layers may be at least partially fragmented during separation. It will be understood that, in general, the degree of fragmentation of the one or more layers including the functionalised surface layer will be different from that of the one or more remaining layers. This allows the one or more layers including the functionalised surface layer to be collected separately from the one or more remaining layers, based on the degree of fragmentation (such as, for example, by sieving).

In embodiments not related to the present invention, separation of one or more layers including the functionalised surface layer from the remaining layers may involve delamination of the layers, or may involve ablation of the remaining layers to leave the one or more layers including the functionalised surface layer. Such ablation may be by means of irradiation with actinic radiation (such as laser ablation), by chemical attack, or by physical ablation (such as through friction, for example by grinding). In some cases it may alternatively be possible to ablate the one or more layers including the functionalised surface layer to leave the remaining layers without significantly affecting the functionalisation of the functionalised surface.

Separating one or more layers of substrate comprises making a series of cuts across the layers to be separated, and thereby causing the layers to delaminate from the laminar substrate. The cuts may be made by hand, but are preferably made using an automated cutting device. For example, the cuts may be made using a dicing machine such as those known for use in cutting silicon wafer. Such devices are able to make cuts of very precise width, depth and separation (pitch), and hence enable the rapid removal of the functionalised surface layer from the remaining layers of the substrate in a reproducible manner.

In some further embodiments, the cuts have a pitch of 0.5 to 3 mm.

In some further embodiments, the cuts have a depth of 50 to 200 µm. For example, such depths may be used with a tape having a thickness of 0.5 mm. Alternatively or additionally, the cuts may have a depth which is less than 50%, less than 45%, or less than 40% of the tape thickness, and/or at least 5% or at least 10% of the tape thickness. For example, the cuts may have a depth of up to 50% of the tape thickness, 5-45% of the tape thickness, or 10-40% of the tape thickness.

In some embodiments, the method further comprises separating pieces of the functionalised substrate. It may be necessary to separate the pieces of functionalised substrate to ensure that the correct quantity of material is provided for the desired application, or to maximise the availability of the functionalised surface. In some further embodiments, separating pieces of the functionalised substrate may comprise forming a powder. Separating pieces of the functionalised substrate may take place simultaneously with separation of one or more layers including the functionalised surface layer from one or more remaining layers of the substrate. Alternatively, one or more layers may first be separated from one or more remaining layers of the substrate, with subsequent separation of the functionalised substrate into pieces.

In some embodiments, the method further comprises comminution of the separated pieces of the functionalised substrate. Such comminution may be by means of grinding, crushing, or other suitable means. Such comminution further increases the surface area of the substrate, and allows the functionalised substrate to be more easily mixed with other substances (such as for example a reaction mixture for which the functionalised substrate has catalytic properties).

According to an aspect not related to the invention, there is provided a functionalised substrate producible according to a method of the first aspect. Such functionalised substrate will have a relatively high proportion of functionalised surface area to volume.

According to an aspect not related to the invention, there is provided a composite laminar substrate having a base layer, a surface layer, and a sacrificial layer positioned between the base layer and the surface layer. Such a composition is particularly suitable for use as the substrate in the method of the first aspect.

It will be understood that the sacrificial layer and surface layer will generally be different in composition; the base layer may be of similar composition to either the sacrificial layer or surface layer, or all three layers may be of different composition.

The composition of the sacrificial layer should be such that the surface layer may easily be separated from the base layer. For example, the sacrificial layer may have a lower (compared to the surface layer or the base layer) degree of resistance to degradation (such as chemical degradation or degradation caused by actinic radiation, such as for example electromagnetic radiation). Alternatively or additionally, the sacrificial layer may have a significantly greater solubility in certain solvents, or may be convertible (such as by exposure to actinic radiation) to a composition having greater solubility. Alternatively or additionally, the sacrificial layer may have a relatively low degree of adhesion to the surface layer.

In some embodiments, the sacrificial layer comprises a positive-tone photoresist material. Thus, exposure of the sacrificial layer to actinic radiation increases the solubility of the sacrificial layer to a photoresist developer, allowing removal of the sacrificial layer and hence separation of the surface layer from the base and sacrificial layers. Suitable positive-tone photoresist materials will be apparent to the skilled man. It will be apparent that, in such cases, the surface layer must be resistant to any degradation caused by the irradiation and/or the photoresist developer.

In general, the choice of substrate material (and particularly the surface layer) will be familiar to the skilled reader. Typically, at least the surface layer of the substrate will be relatively inert to chemical attack. It may also be advantageous for at least the surface layer of the substrate material to be non-toxic to human or other life. In many cases, the substrate will have a flat (or substantially flat) surface (at the atomic level) to allow metallic clusters to be deposited as required. Suitable substrate materials may, in certain applications, include those selected from metals, metal oxides (e.g. SnO, MgO, TiO₂), transition metal chalcogenides, silicon, and graphite. In particular, examples of laminar materials suitable for forming the surface layer of the substrate include graphite and MoS₂.

The following comments relate to all aspects of the invention as appropriate. As used herein, 'metallic clusters' is intended to refer to small groups of metallic atoms. Each 'cluster' may be a single atom, or may contain multiple atoms (up to a few thousand). However, as will be well understood by the skilled reader, metallic clusters are easily distinguished from bulk metal both by size and by characteristics. Individual clusters may comprise atoms of one element only, or atoms of more than one element. One or more non-metallic elements may be present as minor components within the metallic clusters. Separate clusters may have chemical compositions which are the same or different from each other.

Of particular interest are metallic clusters which exhibit catalytic or other functional properties. In particular, clusters of palladium, platinum, gold, silver, cobalt, nickel, and combinations thereof are known to be useful.

In some embodiments, the clusters have a pre-determined range of sizes. The preparation of size-selected clusters is well know in art, through, for example filtering of clusters from a cluster source by mass or energy using a time-of-flight mass filter. Thus, for example, the clusters may have sizes which are within 50%, 40%, 30%, 20%, 10% or 5% of a mean or median value. Alternatively or additionally, at least 80%, at least 90%, at least 95% or at least 99% of the clusters may have the same size. Exemplary clusters include Pd₅₅, Pd₃₀₉, and bilayer clusters of 0.5 nm diameter containing iron oxide and approximately 10 gold atoms (A. A. Herzing et al, Science, 321 (2008) 1331).

An embodiment of a method according to the first aspect of the invention will now be described by way of example.

A 1 m roll of 5 mm wide, 0.5 mm thick flexible graphite tape (commercially available from the Mineral Seal Corporation of Tucson, Arizona) was mounted on a tape driver within a vacuum chamber containing a custom-built RF magnetron sputtering gas condensation cluster beam source with a Pd target.

The cluster source consists of three main parts. The first part generates clusters of various sizes from a liquid nitrogen-cooled magnetron-sputtering source. An Ar plasma is ignited in front of the metal Pd target and the target is bombarded with Ar⁺ ions. In this process, atoms are sputtered off the target. The atoms mix with He gas (which conducts heat to the liquid nitrogen-cooled chamber wall), causing clusters to form as a result of collisions between the metal (Pd) atoms. In the second stage, these clusters are extracted using joint optics and accelerated and focussed into a well-defined beam. In the final stage, clusters are size-selected according to their mass using a time-of-flight mass filter.

The tape was moved through the cluster beam at a rate of 2.5 mm/s, and Pd₅₅ clusters were deposited on the surface of the tape. The diameter of the clusters following deposition depends on the cluster deposition energy. For example, a Pd₅₅ cluster with a deposition energy of 2 keV has a diameter of 3.1 nm, whilst a similar cluster with a deposition energy of 2.5 keV has a diameter of 2.8 nm (as measured by a scanning tunnelling microscope, STM). The clusters formed a submonolayer on the surface of the tape, with spacing between adjacent clusters of approximately 10 nm.

Following deposition, the tape was removed from the vacuum chamber and mounted on UV tape (commercially available as G-260H D-210 from Disco Corporation, Tokyo, Japan) for dicing. The tape was placed in a Disco DAD321 automatic dicing saw using a diamond blade (part number ZH05-SD2000-N1-110) with a spindle speed of 3000 rpm and a feed speed of 20.00 mm/s. A series of parallel cuts were made across the functionalised surface of the graphite tape, with a cutting pitch of 1 mm and a depth of 50 µm. The surface layers of the graphite were then removed with a knife to obtain approximately 33 mg of functionalised graphite powder from a 10 cm length of graphite tape. The initial particle size of the graphite powder was 0.1 x 0.5 mm, with a thickness of 0.1 mm.

In order to test the suitability of the powder for use in chemical reactions, 22 mg of the graphite powder was added to 1 ml of chlorobenzene. Stirring (using a magnetic stirrer) or sonication resulted in comminution of the graphite powder, giving a decrease of the graphite particle size (to between 20 and 200 µm, as measured by a scanning electron microscope, SEM), and the particles were well dispersed in the solvent without aggregation.

Similar results were obtained with cutting pitches of 0.5 to 3 mm and cutting depths of 50 to 200 µm.

An embodiment of a substrate according to the third aspect of the invention will now be described by way of example.

A 10 cm square of 5 mm thick borosilicate (quartz) glass (transparent to UV radiation) is coated on one side with a 100 nm layer of a UV-sensitive positive-tone photoresist. A 5 nm coating of graphite is then applied to the photoresist by sputtering. Thus, the resulting composite has a base layer of borosilicate glass, a sacrificial layer of positive-tone photoresist, and a surface layer of graphite.

The substrate is suitable for use in the method of the first aspect of the invention. Following deposition of metallic clusters on the graphite layer, the positive-tone photoresist can be irradiated with UV through the borosilicate glass. Treatment with the appropriate developer then dissolves the irradiated photoresist, releasing the functionalised surface layer from the base layer.

## Claims

1. A method of producing a substrate functionalised with metallic clusters, comprising providing a laminar substrate, depositing metallic clusters on a surface of the substrate to thereby create a functionalised surface layer, and separating one or more layers of the substrate including the functionalised surface layer from one or more remaining layers of the substrate, wherein separating one or more layers of substrate comprises making a series of cuts across the layers to be separated, and thereby causing the layers to delaminate from the laminar substrate.

2. The method as claimed in claim 1, wherein the laminar substrate is a composite structure comprising at least two different layers, optionally the at least two different layers have different chemical compositions.

3. The method as claimed in claim 2, wherein the substrate comprises a base layer, a surface layer, and a sacrificial layer positioned between the base layer and the surface layer, and depositing metallic clusters on a surface of the substrate comprises depositing metallic clusters on the surface layer, and wherein separating one or more layers of the substrate including the functionalised surface layer from one or more remaining layers of the substrate comprises selectively removing the sacrificial layer.

4. The method as claimed in any one of claims 1 to 3, wherein depositing metallic clusters on a surface of the substrate to thereby create a functionalised surface layer comprises (i) placing the substrate in a vacuum chamber and directing clusters towards the substrate by the use of electromagnetic fields or (ii) depositing metallic clusters onto the substrate from a solution.

5. The method as claimed in any one of claims 1 to 4, wherein separating one or more layers of the substrate including the functionalised surface layer from one or more remaining layers of the substrate comprises (i) separation of one or more intact layers including the functionalised surface layer from one or more intact remaining layers, or (ii) fragmentation of one or both of the one or more layers including the functionalised surface layer and the one or more remaining layers.

6. The method as claimed in any one of claims 1 to 5, making a series of cuts across the layers to be separated comprises use of an automated cutting device.

7. The method as claimed in any preceding claim , wherein the cuts are made by a blade or a laser.

8. The method as claimed in any preceding claim, wherein the cuts have a pitch of 0.5 to 3 mm.

9. The method as claimed in any preceding claim, wherein the cuts have a depth of 50 to 200 µm and/or a depth of less than 50% of the substrate thickness.

10. The method as claimed in any one of claims 1 to 9, further comprising separating pieces of the functionalised substrate, optionally forming a powder.

11. The method as claimed in any one of claims 1 to 10, wherein the metallic clusters comprise clusters of palladium, platinum, gold, silver, cobalt, nickel, and combinations thereof.

12. The method as claimed in any one of claims 1 to 11, wherein the metallic clusters have a predetermined range of sizes.

## Patentansprüche

1. Verfahren zur Herstellung eines funktionalisierten Substrats mit Metallclustern, beinhaltend Bereitstellen eines laminaren Substrats, Ablagern von Metallclustern auf einer Oberfläche des Substrates, um hierdurch eine funktionalisierte Oberflächenschicht zu schaffen und Trennen einer oder mehrerer Schichten des Substrates, darunter die funktionalisierte Oberflächenschicht, von einer oder mehreren verbleibenden Schicht(en) des Substrates, wobei Trennen einer oder mehrerer Schicht(en) von Substrat das Praktizieren einer Reihe von Schnitten durch die zu trennenden Schichten beinhaltet, und hierbei die Schichten veranlasst werden, sich vom laminaren Substrat zu delaminieren.

2. Verfahren nach Anspruch 1, bei welchem das laminare Substrat eine Verbundstruktur ist, welche mindestens zwei unterschiedliche Schichten beinhaltet, wobei optionsweise die mindestens zwei unterschiedlichen Schichten unterschiedliche chemische Zusammensetzungen besitzen.

3. Verfahren nach Anspruch 2, bei welchem das Substrat eine Grundschicht, eine Oberflächenschicht und eine Opferschicht beinhaltet, welche zwischen der Grundschicht und der Oberflächenschicht positioniert ist, und wobei Ablagern von Metallclustern an einer Oberfläche des Substrates Ablagern von Metallclustern an der Oberflächenschicht beinhaltet, und wobei Trennen einer oder mehrerer Schicht(en) des Substrates, darin inbegriffen die funktionalisierte Oberflächenschicht, von einer oder mehreren verbleibenden Schicht(en) des Substrates selektives Entfernen der Opferschicht beinhaltet.

4. Verfahren nach einem der Ansprüche 1 bis 3, bei welchem Ablagern von Metallclustern an einer Oberfläche des Substrates zum Schaffen einer funktionalisierten Oberflächenschicht Folgendes beinhaltet: (i) Platzieren des Substrates in einer Vakuumkammer und Richten von Clustern auf das Substrat unter Verwendung von elektromagnetischen Feldern oder (ii) Ablagern von Metallclustern am Substrat aus einer Lösung.

5. Verfahren nach einem der Ansprüche 1 bis 4, bei welchem Trennen einer oder mehrerer Schicht(en) des Substrates, darin inbegriffen die funktionalisierte Oberflächenschicht, von einer oder mehreren verbleibenden Schicht(en) des Substrates Folgendes beinhaltet: (i) Trennen von einer oder mehreren intakten Schicht(en), darin inbegriffen die funktionalisierte Oberflächenschicht, von einer oder mehreren intakten, verbleibenden Schicht(en), oder (ii) Fragmentieren von einer oder beiden der einen oder mehreren Schicht(en), darin inbegriffen die funktionalisierte Oberflächenschicht und die eine oder mehr verbleibende(n) Schicht(en).

6. Verfahren nach einem der Ansprüche 1 bis 5, bei welchem Praktizieren einer Reihe von Schnitten durch die zu trennenden Schichten den Gebrauch einer automatischen Schneidvorrichtung beinhaltet.

7. Verfahren nach einem der vorhergehenden Ansprüche, bei welchem die Schnitte durch eine Klinge oder einen Laser praktiziert werden.

8. Verfahren nach einem der vorhergehenden Ansprüche, bei welchem die Schnitte einen Abstand zwischen 0,5 und 3 mm besitzen.

9. Verfahren nach einem der vorhergehenden Ansprüche, bei welchem die Schnitte eine Tiefe von 50 bis 200 µm und/oder eine Tiefe unter 50 % der Substratdicke besitzen.

10. Verfahren nach einem der Ansprüche 1 bis 9, zudem beinhaltend Trennen von Teilen des funktionalisierten Substrates, und optionsweise, Bilden eines Pulvers.

11. Verfahren nach einem der Ansprüche 1 bis 10, bei welchem die Metallcluster Cluster aus Palladium, Platin, Gold, Silber, Kobalt, Nickel und Kombinationen hieraus sind.

12. Verfahren nach einem der Ansprüche 1 bis 11, bei welchem die Metallcluster einen vorbestimmten Größenbereich besitzen.

## Revendications

1. Procédé de production d'un substrat fonctionnalisé avec des agrégats métalliques, comprenant les étapes consistant à fournir un substrat laminaire, déposer des agrégats métalliques sur une surface du substrat afin de créer ainsi une couche de surface fonctionnalisée, et séparer une ou plusieurs couche(s) du substrat, y compris la couche de surface fonctionnalisée, par rapport à une ou plusieurs couche(s) restante(s) du substrat, dans lequel l'étape de séparation d'une ou plusieurs couche(s) du substrat comprend une étape consistant à réaliser une série de découpes à travers les couches à séparer, et provoquer ainsi la délamination des couches par rapport au substrat laminaire.

2. Procédé selon la revendication 1, dans lequel le substrat laminaire est une structure composite comprenant au moins deux couches différentes, lesdites au moins deux couches différentes présentant éventuellement différentes compositions chimiques.

3. Procédé selon la revendication 2, dans lequel le substrat comprend une couche de base, une couche de surface, et une couche sacrificielle positionnée entre la couche de base et la couche de surface, et l'étape de dépôt d'agrégats métalliques sur une surface du substrat comprend une étape consistant à déposer des agrégats métalliques sur la couche de surface, et dans lequel l'étape de séparation d'une ou plusieurs couche(s) de substrat, y compris la couche de surface fonctionnalisée, par rapport à une ou plusieurs couche(s) restante(s) du substrat comprend une étape consistant à retirer de manière sélective la couche sacrificielle.

4. Procédé selon l'une quelconque des revendications 1 à 3, dans lequel l'étape de dépôt d'agrégats métalliques sur une surface du substrat afin de créer ainsi une couche de surface fonctionnalisée comprend les étapes consistant à (i) placer le substrat dans une chambre à vide et guider des agrégats vers le substrat à l'aide de champs électromagnétiques, ou à (ii) déposer des agrégats métalliques sur le substrat à partir d'une solution.

5. Procédé selon l'une quelconque des revendications 1 à 4, dans lequel l'étape de séparation d'une ou plusieurs couche(s) du substrat, y compris la couche de surface fonctionnalisée, par rapport à une ou plusieurs couche(s) restante(s) du substrat comprend (i) une séparation d'une ou plusieurs couche(s) intacte(s), y compris la couche de surface fonctionnalisée, par rapport à une ou plusieurs couche(s) restante(s) intacte(s), ou (ii) une fragmentation d'une ou les deux parmi la ou les couche(s), y compris la couche de surface fonctionnalisée, et la ou les couche(s) restante(s).

6. Procédé selon l'une quelconque des revendications 1 à 5, dans lequel l'étape de réalisation d'une série de découpes à travers les couches à séparer comprend l'utilisation d'un dispositif de coupe automatisé.

7. Procédé selon l'une quelconque des revendications précédentes, dans lequel les découpes sont réalisées à l'aide d'une lame ou d'un laser.

8. Procédé selon l'une quelconque des revendications précédentes, dans lequel les découpes présentent un pas compris entre 0,5 et 3 mm.

9. Procédé selon l'une quelconque des revendications précédentes, dans lequel les découpes présentent une profondeur comprise entre 50 et 200 µm et/ou une profondeur inférieure à 50 % de l'épaisseur de substrat.

10. Procédé selon l'une quelconque des revendications 1 à 9, comprenant en outre une étape consistant à séparer des pièces du substrat fonctionnalisé, en formant éventuellement une poudre.

11. Procédé selon l'une quelconque des revendications 1 à 10, dans lequel les agrégats métalliques comprennent des agrégats de palladium, de platine, d'or, d'argent, de cobalt, de nickel, et des combinaisons de ceux-ci.

12. Procédé selon l'une quelconque des revendications 1 à 11, dans lequel les agrégats métalliques présentent une plage de tailles prédéterminée.
